(19) **Europäisches Patentamt**
**European Patent Office**
**Office européen des brevets**

(11)  **EP 2 728 609 B1**

(12) **EUROPEAN PATENT SPECIFICATION**

(45) Date of publication and mention
of the grant of the patent:
**18.03.2020 Bulletin 2020/12**

(51) Int Cl.:
*H01L 21/20* *(2006.01)*

(21) Application number: **13191058.0**

(22) Date of filing: **31.10.2013**

(54) **METHOD FOR FABRICATING EPITAXIAL WAFER**

VERFAHREN ZUR HERSTELLUNG EINES EPITAXIALWAFERS

PROCÉDÉ DE FABRICATION DE TRANCHE ÉPITAXIALE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.10.2012 KR 20120122005
30.11.2012 KR 20120137988**

(43) Date of publication of application:
**07.05.2014 Bulletin 2014/19**

(73) Proprietor: **LG Innotek Co., Ltd.
Seoul, 04637 (KR)**

(72) Inventors:
• **Kang, Seok Min
100-714 SEOUL (KR)**
• **Kim, Ji Hye
100-714 SEOUL (KR)**

(74) Representative: **Novagraaf Technologies
Bâtiment O2
2, rue Sarah Bernhardt
CS90017
92665 Asnières-sur-Seine Cedex (FR)**

(56) References cited:
**DE-A1- 19 712 796     JP-A- 2011 121 847
US-A1- 2009 085 044     US-B2- 7 531 433**

**Description**

<u>**TECHNICAL FIELD**</u>

Embodiments relate to an epitaxial wafer and a semiconductor device including the same.

<u>**BACKGROUND**</u>

Epitaxial growth generally includes a chemical vapor deposition process. In accordance with the epitaxial growth, a wafer is heated while a silicon composite of vapor phase/liquid phase/solid phase is transferred to a surface of a single crystal silicon wafer (or substrate) to be thermally decomposed or to have an effect on thermal decomposition. At this time, an epitaxial wafer is fabricated by laminating silicon onto a single crystal silicon wafer through continuous growth of a single crystal structure. In the case in which an epitaxial wafer having a certain polarity such as n-type or p-type is fabricated, a predetermined doping gas is injected into a chamber in the epitaxial growth process.

It is essential that doping uniformity of the doped epitaxial wafer satisfy a tolerance according to design specification. For this purpose, there is a conventional method wherein doping concentrations of a wafer, a buffer layer and an active layer differ and a doping concentration of the buffer layer is higher than that of the active layer. However, in spite of using this method, a desired level of doping uniformity cannot be satisfied.

<u>**SUMMARY**</u>

An object of the present invention is a method for fabricating an epitaxial wafer comprising a silicon carbide substrate and an epitaxial structure disposed on the silicon carbide substrate, said epitaxial structure comprising a first epitaxial layer and a second epitaxial layer disposed on the first epitaxial layer, each of the first and second epitaxial layers comprising silicon carbide, comprises the following steps:

- a step of disposing the silicon carbide substrate in a reaction chamber;
- a step of injecting in the reaction chamber a reactive gas include a growth gas for epitaxial growth and a doping gas,

wherein said growth gas includes silicon and carbon, wherein said doping gas includes dilution gas and a source gas containing said an n-type or p-type dopant,

- a step of rotating said silicon carbide substrate at a predetermined and controlled rotation speed that is set to be comprised between 50 rpm and 100 rpm, and controlling the dilution ratio of the source gas in the doping gas according to equation 2:

$$\text{equation 2:}$$
$$\text{dilution ratio = flux of source gas / flux of doping gas}$$

- a step of growing an epitaxial layer comprising a pregrowing step of a first epitaxial layer on the silicon carbide substrate, and a growing step of a second epitaxial layer on the first epitaxial layer ;

wherein during the pregrowth step, the dilution ratio of the source gas is controlled to be set within 1/70 to 1/30 when the C/Si ratio of the epitaxial layers is of 0,7 to less than 1, and
during the growth step the dilution ratio of the source gas is controlled to be set within 1/100 to 1/10 when the C/Si ratio of the epitaxial layers is 1 or more,
thus leading to a standard deviation from the mean concentration of dopant of said epitaxial structure from a center of the epitaxial wafer to the edge thereof of 10 % or less of the mean concentration of dopant.

The doping standard deviation from the mean concentration of dopant of said epitaxial structure from a center of the epitaxial wafer to the edge thereof may be 9% or less of the mean concentration of dopant.

The first epitaxial layer may be disposed between the silicon carbide substrate and the second epitaxial layer so that leakage current induced when applying voltage to the epitaxial wafer is suppressed.

The first epitaxial layer may be disposed between the silicon carbide substrate and the second epitaxial layer so that lattice mismatch between the silicon carbide substrate and the second epitaxial layer is reduced, thereby reducing surface defects of the second epitaxial layer.

The second epitaxial layer may have a surface defect density of $0.5/cm^2$ or less.

The composition of the first epitaxial layer may be the same as that of the second epitaxial layer.

The first epitaxial layer may be doped at a first doping concentration, the second epitaxial layer may be doped at a second doping concentration, and the first doping concentration may be greater than the second doping concentration.

According to a first embodiment, each of the first and second epitaxial layers doped with an n-type dopant may comprises silicon carbon nitride (SiCN).

According to another embodiment, each of the first and second epitaxial layers doped with a p-type dopant may comprises aluminum silicon carbide (AlSiC).

The first epitaxial layer may have a thickness of 1.0 $\mu$m or less, and preferably of 0.5 $\mu$m to 1.0 $\mu$m.

The growing of the epitaxial structure includes growing a first epitaxial layer on the substrate and growing a second epitaxial layer on the first epitaxial layer, wherein the growing of the first epitaxial layer and the growing of the second epitaxial layer may be continuously performed without intermission.

The first epitaxial layer may be grown at a first growth speed, the second epitaxial layer may be grown at a second growth speed, and the first growth speed may be lower than the second growth speed.

The doping and growing of the epitaxial structure may further include intermediate growth performed by injecting the reactive gas onto the substrate at a growth speed which increases linearly or stepwise from the first growth speed to the second growth speed, after the growing of the first epitaxial layer and before the growing of the second epitaxial layer.

The doping gas may include nitrogen and the diluent gas contained in the reactive gas may include hydrogen.

## BRIEF DESCRIPTION OF THE DRAWINGS

Arrangements and embodiments will be described in detail with reference to the following drawings in which like reference numerals refer to like elements and wherein:

FIGs. 1A to 1C are sectional views illustrating a method for fabricating an epitaxial wafer according to an embodiment;

FIG. 2 is a flowchart illustrating a method for fabricating an epitaxial wafer according to an embodiment;

FIG. 3 is a graph showing doping uniformity of an epitaxial wafer fabricated by the method for fabricating the epitaxial wafer according to the embodiment;

FIG. 4 is a sectional view illustrating an epitaxial wafer according to an embodiment not forming part of the invention;

FIG. 5 is a sectional view of an epitaxial wafer according to another embodiment not forming part of the invention;

FIG. 6 is a flowchart illustrating a method for fabricating an epitaxial wafer according to another embodiment not forming part of the invention;

FIGs. 7 and 8 show a buffer layer and an active layer epitaxially doped and grown according to an example not forming part of the invention; and

FIGs. 9 and 10 show a buffer layer and an active layer epitaxially doped and grown according to a comparative example.

## DESCRIPTION OF SPECIFIC EMBODIMENTS

Reference will now be made in detail to the preferred embodiments, examples of which are illustrated in the accompanying drawings. The disclosure should not be construed as limited to the embodiments set forth herein and includes modifications, variations, equivalents and substitutions compliant with the spirit and scope of the disclosure defined by the appended claims. Use of the term "embodiment" does not imply that the subject-matter in question should be considered as forming part of the invention.

It will be understood that, although the terms including the ordinal numbers such as first or second may be used herein to describe various elements, these elements should not be limited by these terms. These terms are only used to distinguish one element from another element. For example, a first element could be termed second element and a second element could be termed first element without departing from the teachings of the present invention. The term "and/or" includes each of a plurality of related items or a combination thereof.

The terminology used in the present disclosure is for the purpose of describing particular embodiments only and is not intended to limit the disclosure. As used in the disclosure and the appended claims, the singular forms are intended to include the plural forms as well, unless context clearly indicates otherwise. It will be further understood that the terms "comprises" and/or "has" when used in this specification, specify the presence of stated features, integers, steps, operations, elements, components or combinations thereof, but do not preclude the presence or addition of one or more other features, integers, steps, operations, elements, components, and/or combinations thereof.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

It will be understood that when an element such as a layer, film, region or substrate is referred to as being "on" another element such as a layer, film, region or substrate, it can be directly on the other element or intervening elements may also be present. In contrast, when an element is referred to as being "directly on" another element, there are no intervening elements.

Hereinafter, embodiments will be described in detail with reference to the annexed drawings. Wherever possible, the same reference numbers will be used throughout the drawings to refer to the same or like parts. Repeated descriptions are omitted.

The present embodiment provides a method for fabricating an epitaxial wafer which has a doping uniformity from a center to an edge of 10% or less, in particular, 9% or less.

Here, the doping uniformity of the epitaxial wafer means a percentage of a standard deviation to a mean of a doping concentration and may be represented by the following Equation 1

[Equation 1]

$$\text{doping uniformity (\%)} = (\sigma / \text{mean}) \times 100$$

Here, mean represents mean of doping concentration, and $\sigma$ represents a standard deviation of the doping concentration. The more a value of doping uniformity (%) decreases, the more doping is evened.

In accordance with the present embodiment, the doping uniformity of the epitaxial wafer may be improved by parameters during a doping process such as temperature, pressure, C/Si ratio, Si/$H_2$ ratio, rotation speed of substrate (or wafer), dilution ratio of doping gas, ratio of diluent gas to source gas and the like.

Among the afore-mentioned parameters, the dilution ratio of the source gas corresponding to an actually doped element of the injected doping gas may act as the most essential parameter in order to improve doping uniformity. Accordingly, a method for fabricating an epitaxial wafer according to the invention contributes to improvement in doping uniformity through the dilution ratio of the source gas. Hereinafter, the epitaxial wafer and a method for fabricating the same according to the embodiment will be described with reference to the annexed drawings.

In accordance with the invention, an epitaxial wafer evenly doped from a center to an edge may be fabricated to have a doping uniformity with an error range of 10% or less. The dilution ratio of the source gas in the doping gas injected for this purpose is suitably controlled according to C/Si ratio and a rotation speed of the substrate is also suitably controlled thereby.

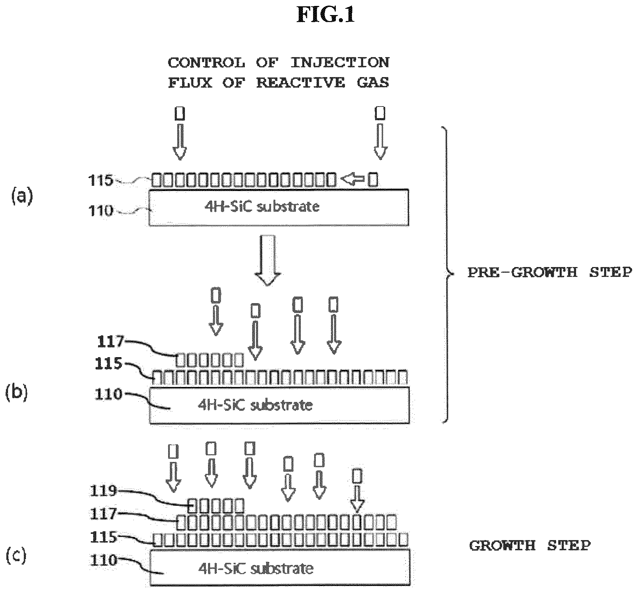

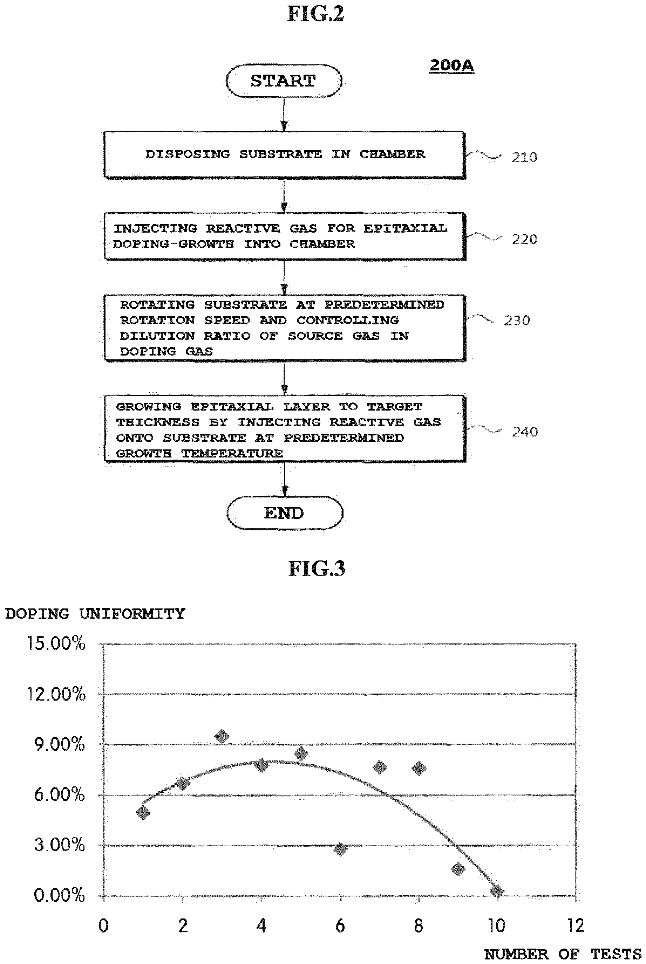

FIGs. 1A to 1C are sectional views illustrating a method 200A for fabricating an epitaxial wafer according to an embodiment. FIG. 2 is a flowchart illustrating a method 200A for fabricating an epitaxial wafer according to an embodiment.

Hereinafter, the method 200A for fabricating an epitaxial wafer exemplarily shown in FIG. 2 will be described with reference to FIGs. 1A to 1C, but the embodiment is not limited to the sectional views shown in FIGs. 1A to 1C.

In accordance with the method 200A for fabricating an epitaxial wafer according to the invention as exemplarily shown in FIG. 1A, a substrate 110 is disposed in a reaction chamber (not shown) (step 210). Here, the substrate 110 may be a semiconductor substrate and is for example a silicon carbide-based substrate. In addition, the substrate 110 may be a 4H-SiC substrate as shown in FIGs. 1A to 1C, but the embodiment is not limited thereto. That is, a substrate such as 6H-SiC, 3C-SiC or 15R-SiC other than the 4H-SiC substrate 110 may be used according to type of elements or products finally formed on the epitaxial wafer according to the embodiment.

After the step 210, a reactive gas (or reactive source) is injected into a chamber and the substrate 110 is rotated, to grow epitaxial layers 115, 117 and 119 on the substrate 110 (Steps 220 to 240).

Here, an epitaxial structure may include a plurality of epitaxial layers 115, 117 and 119, but the embodiment is not limited thereto. When a lamination layer (not shown) is formed by laminating or growing a material made of a certain substance on the substrate 110, it may be difficult to secure reliability of the lamination layer due to lattice constant mismatch between the substrate 110 and the lamination layer. In order to solve this problem, as exemplarily shown in FIG. 1A, the epitaxial layer 115 may be laminated as the buffer layer on the substrate 110. Then, as exemplarily shown in FIG. 1B, the first epitaxial layer 117 is grown on the buffer layer 115. Then, as exemplarily shown in FIG. 1C, the second epitaxial layer 119 is grown on the first epitaxial layer 117. Here, the growth of the buffer layer 115 may be omitted.

First, a reactive gas for epitaxial doping growth on the substrate 110 is injected (Step 220). Here, the reactive gas includes a growth gas serving as a source of epitaxial growth and a doping gas used for doping during the growth process.

The afore-mentioned doping gas includes a source gas corresponding to an element which is actually doped on the epitaxial layers 115, 117 and 119 laminated by epitaxial growth and a diluent gas used for diluting the source gas.

According to the invention when the reactive gas is injected into the chamber, a rotation speed of the substrate 110 is controlled (or adjusted) and a dilution ratio of the source gas in the doping gas is controlled (Step 230). In accordance with the method 200A for fabricating the epitaxial wafer exemplarily shown in FIG. 2, after the step 220, the step 230 is performed and the step 240 is then performed. However, the steps 220 to 240 may be simultaneously performed. The controls of the rotation speed of the substrate 110 and the dilution ratio of the source gas may be performed as follows.

First, in the case in which the substrate 110 on which epitaxial growth is performed is a silicon carbide-based substrate (for example, 4H-SiC substrate), as exemplarily shown in FIGs. 1A to 1C, a liquid, vapor or solid substance (or compound) containing carbon and silicon such as $SiH_4+C_3H_8+H_2$, MTS ($CH_3SiCl_3$), TCS ($SiHCl_3$), $Si_xC_x$ ($1 \leq x \leq 17$), $Si_xC_y$ ($1 \leq x \leq 17$, $1 \leq y \leq 18$) which is a material which matches in lattice constant with the substrate 110 may be used as the growth gas for epitaxial growth. In the case in which the epitaxial layers 115, 117 and 119 laminated on the substrate 110 through the epitaxial growth process described above are doped with an n-type dopant, a Group V element such as nitrogen ($N_2$) gas may be used as the source gas, but the embodiment is not limited as to the substance of the source gas.

In addition, the reactive gas may be changed according to material and type of the substrate 110 on which the epitaxial layers 115, 117 and 119 are laminated. In addition, the source gas actually involved in doping may also be changed according to doping type (n-type or p-type). For convenience and concentration of description, the following description is based on the assumption that epitaxial doping- growth is performed on the silicon carbide-based substrate 110 using a nitrogen gas as the source gas, but the embodiment is not limited thereto.

In addition, the description is based on the assumption that a hydrogen ($H_2$) gas is used as the diluent gas for diluting the nitrogen gas used as the source gas, but the embodiment is not limited thereto. For example, an inert gas (for example, Ar or He) may be used as the diluent gas.

Regarding the doping gas injected in the step 220, the dilution ratio of the source gas may be represented by the following Equation 2.

[Equation 2]

$$\text{dilution ratio} = \text{flux of source gas} / \text{flux of doping gas}$$

corresponding to the doping element actually doped on the epitaxial layers 115, 117 and 119, of the doping gas injected into the chamber, may be determined according to ratio of carbon to silicon (C/Si) of the epitaxial structures 115, 117 and 119. When the ratio (C/Si) of the epitaxial layers 115, 117 and 119 is 1 or more, in the case in which the dilution ratio of the source gas is less than 1/100 or higher than 1/10, the doping uniformity represented by Equation 1 may be deteriorated. Accordingly, the dilution ratio of the source gas is set within 1/100 to 1/10 when the C/Si ratio of the epitaxial layers 115, 117 and 119 is 1 or more.

In addition, when the C/Si ratio of the epitaxial layers 115, 117 and 119 is lower than 1, in the case in which the dilution ratio of the source gas is lower than 1/70 or is higher than 1/30, the doping uniformity represented by Equation 1 may be deteriorated. Accordingly, the dilution ratio of the source gas is controlled to set within 1/70 to 1/30 when the C/Si ratio of the epitaxial layers 115, 117 and 119 is lower than 1.

In addition, the doping gas is supplied through an inlet provided in the chamber and is discharged through an outlet, thereby maintaining a constant concentration o of the doping gas in the chamber. However, because, in actual, the doping concentration of an area in which the inlet is disposed may be higher than the doping concentration of an area in which the outlet is disposed, supply of a doping gas at a uniform concentration over the entire surface from a center to an edge of the substrate 110 may be disadvantageously impossible. Accordingly, in accordance with the embodiment, when the epitaxial layers 115, 117 and 119 are grown, the substrate 110 is rotated. When the rotation speed of the substrate 110 is less than 50 rpm or is higher than 100 rpm, the doping uniformity of the epitaxial wafer may be deteriorated. Accordingly, when the rotation speed of the substrate 110 is controlled to within 50 rpm to 100 rpm, the constant concentration of the doping gas supplied to the substrate 110 can be maintained.

FIG. 3 is a graph showing doping uniformity of epitaxial wafers fabricated by the method 200A for fabricating an epitaxial wafer according to the invention. In FIG. 3, an x-axis represents the number of tests and a y-axis represents doping uniformity of the epitaxial wafer.

A test example exemplified shown in FIG. 3 is obtained by performing epitaxial doping and growth at the dilution ratio of the source gas described above, while rotating the substrate 110 at the speed described above. It can be seen from FIG. 3 that doping uniformities of all 10 tests satisfy an error range of 10% or less. As can be seen from the fact that generally-used products have typically doping uniformity with an error range of 15% or less, doping uniformity of epitaxial layers 115, 117 and 119 doped and grown under the conditions according to the embodiment is considerably excellent.

Consequently, in accordance with the method 200A for fabricating the epitaxial wafer exemplified shown in FIG. 2, considerably excellent doping uniformity can be secured simply by controlling the rotation speed of the substrate 110 while suitably controlling the dilution ratio of the source gas according to C/Si ratios of the epitaxial layers 115, 117 and 119.

The epitaxial growth through the condition control as aforementioned is continued until the epitaxial layer is grown to the designed target thickness as shown in the step 240 of FIG. 2. That is, during the steps 220 and 230, epitaxial layers 115, 117 and 119 are grown on the substrate 110 (Step 240).

The epitaxial layers 115, 117 and 119 may be formed on the substrate 110 as follows.

The method 200A for fabricating the epitaxial wafer according to the present embodiment includes a pre-growth step shown in FIGs. 1A and 1B, and a growth step shown in FIG. 1C.

In the pre-growth step, epitaxial layers 115 and 117 are grown to a predetermined first thickness at a predetermined first growth speed and at a first growth temperature by injecting a reactive gas for epitaxial growth onto the substrate 110 provided in a chamber.

In the growth step, an epitaxial layer 119 is grown to a target thickness at a predetermined second growth speed and at a second growth temperature by injecting the reactive gas onto the substrate 110. The first growth speed is lower than the second growth speed, and the growth step and the pre-growth step are continuously performed without intermission.

The first growth speed may be for example set to a speed of 3 $\mu$m/h to 5 $\mu$m/h or less (that is, a speed at which the epitaxial layers 115 and 117 are laminated to a thickness of 3 $\mu$m or less or 5 $\mu$m or less per hour). Each of the first and second growth speeds may be controlled by controlling flux of the reactive gas injected into the chamber.

In general, when the epitaxial layers 117 and 119 are grown at a high speed, it may be difficult to uniformly laminate or grow the epitaxial layers 117 and 119. Accordingly, in accordance with the pre-growth step, mobility between atoms through the reactive gas is activated by maintaining the predetermined first growth temperature, thereby providing an environment enabling even growth, and time enabling the atoms to be uniformly distributed and grown on the substrate 110 can be secured by reducing the growth speed. Accordingly, because the epitaxial layers 115 and 117 are grown on the substrate 110 by the pre-growth step before the epitaxial layer 119 is grown, lattice mismatch between the substrate 110 and the epitaxial layer 119 is reduced and surface defects of the epitaxial layer 119 is thus considerably reduced.

Accordingly, the pre-growth step is a preliminary process which reduces surface defects caused by lattice mismatch in an early growth stage and thereby aids to the growth step. Accordingly, the range from about 0.5 $\mu$m to about 1.0 $\mu$m is enough for the thickness of the epitaxial layer (115 or/and 117) grown by the pre-growth step. Here, the thicknesses of the epitaxial layer 115 or/and 117 grown through the pre-growth step may be controlled by controlling the first growth temperature, the first growth speed and the growth time.

In the growth step, the epitaxial layer 119 is properly grown on the epitaxial layers 115 and 117 grown based on the pre-growth step. This growth step enables growth of the epitaxial layer 119 at the second growth speed much greater than the first growth speed of the pre-growth step because it is a step after the pre-growth step. For example, the second growth speed may be 20 $\mu$m/h or more and the second growth temperature may be set for example to a range from 1,500°C to 1,700°C. The growth step may be performed until a total thickness of the epitaxial layers 115, 117 and 119 reaches the desired target thickness. At this time, the target thickness may be changed according to utilization purpose and application of epitaxial wafers, features of final elements and products, design specification and the like.

Under the growth conditions described above, it is controlled so that the pre-growth step has a C/Si ratio of 0.7 to less than 1 and the growth step has a C/Si ratio of 1 or more. Accordingly, during the pre-growth and growth steps, the pre-growth step is controlled so as to set the dilution ratio of the source gas to 1/30 to 1/70 and the growth step is controlled so as to set the dilution ratio of the source gas to 1/10 to 1/100.

In accordance with an embodiment, the growth step and the pre-growth step are continuously performed without intermission. That is, the pre-growth step and the growth step may be continuously performed while not stopping injection of the reactive gas (while not stopping the growth step). The continuous performance of the growth step may be carried out by the following methods.

First, the growth step may be performed immediately after the pre-growth step. Alternatively, an intermediate growth step may be interposed between the growth and the pre-growth. The intermediate growth step is a process for growing an epitaxial layer by injecting a reactive gas on the substrate 110 at a growth speed which increases linearly or stepwise from the first growth speed which is a growth speed of the pre-growth step to the second growth speed which is a growth speed of the growth step.

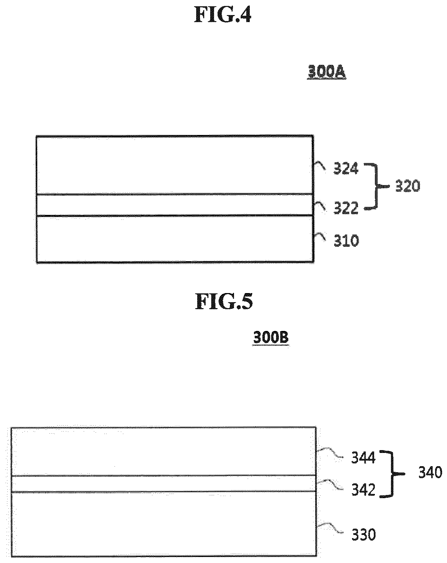

FIG. 4 is a sectional view illustrating an epitaxial wafer 300A according to an embodiment not part of the invention.

The epitaxial wafer 300A exemplarily shown in FIG. 4 includes a substrate (or wafer) 310 and an epitaxial structure 320 disposed on the substrate 310. The substrate 310 may be a semiconductor substrate and may be for example a silicon carbide-based substrate. In this regard, the epitaxial structure 320 may also be a silicon carbide structure. The substrate 310 may correspond to the substrate 110 exemplarily shown in FIGs. 1A to 1C.

The epitaxial structure 320 includes first and second epitaxial layers 322 and 324 and may be doped with an n-type or p-type dopant. The first epitaxial layer 322 is disposed on the substrate 310 and the second epitaxial layer 324 is disposed on the first epitaxial layer 322. The first epitaxial layer 322 and the second epitaxial layer 324 are epitaxially grown in the growth process by rotating the substrate 310 while controlling the dilution ratio of the source gas, thus maintaining a doping uniformity of 10% or less.

The first and second epitaxial layers 322 and 324 may correspond to the first and second epitaxial layers 117 and 119, respectively, shown in FIGs. 1B and 1C. In this case, as described above, the first epitaxial layer 322 and the second epitaxial layer 324 may have the same composition because the pre-growth step for forming the first epitaxial layer 322 and the growth step for forming the second epitaxial layer 324 are continuously performed without stopping injection of the reactive gas.

Leakage current generated upon application of a voltage to the epitaxial wafer 300A can be suppressed by disposing the first epitaxial layer 322 between the substrate 310 and the second epitaxial layer 324. At this time, the first epitaxial layer 322 may have a thickness of 1 $\mu$m or less, for example, a thickness of 0.5 $\mu$m to 1.0 $\mu$m.

The second epitaxial layer 324 may be formed to the target thickness through the aforementioned growth step and have a surface defect density of 0.5/cm$^2$ or less.

The substrate 310 may be a silicon carbide (SiC) substrate and each of the first epitaxial layer 322 and the second epitaxial layer 324 may include silicon carbide. When the substrate 310 is a silicon carbide (SiC) substrate and both the first epitaxial layer 322 and the second epitaxial layer 324 are formed of n-type conductive silicon carbide, each of the first epitaxial layer 322 and the second epitaxial layer 324 may be formed of silicon carbon nitride (SiCN).

Alternatively, when both the first epitaxial layer 322 and the second epitaxial layer 324 are formed of p-type conductive silicon carbide, each of the first epitaxial layer 322 and the second epitaxial layer 324 may be formed of aluminum silicon carbide (AlSiC).

The epitaxial wafer 300A according to the embodiment may have an improved doping uniformity of 10% or less and exhibit high quality such as enhanced properties and yield.

Hereinafter, an epitaxial wafer and a method for fabricating the same according to another embodiment will be described with reference to the annexed drawings.

In accordance with another embodiment, the doping uniformity of the epitaxial wafer may have an error range of 9% or less. For this purpose, the dilution ratio of the source gas in the injected doping gas is suitably controlled according to C/Si ratio and a rotation speed of the substrate is also suitably controlled thereby.

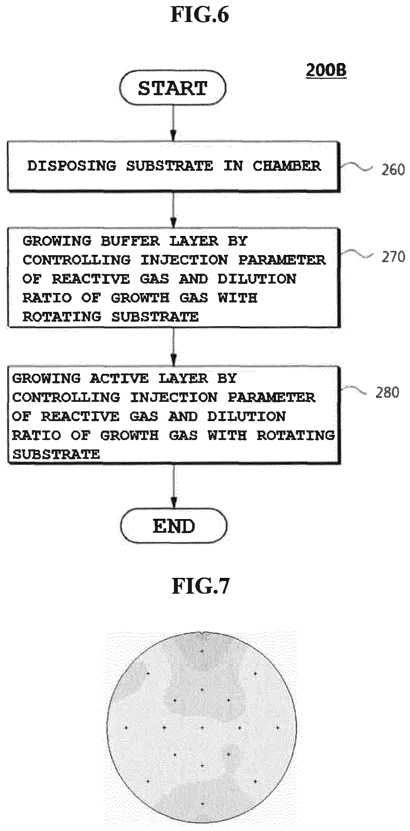

FIG. 5 is a sectional view of an epitaxial wafer 300B according to another embodiment not forming part of the invention. FIG. 6 is a flowchart illustrating a method 200B for fabricating an epitaxial wafer according to another embodiment not forming part of the invention.

Referring to FIG. 5, the epitaxial wafer 300B includes a substrate (or wafer) 330 and an epitaxial structure 340.

The substrate 330 may be the same as the substrates 110 and 310 exemplarily shown in FIGs. 1A to 1C or FIG. 4 and may be a semiconductor substrate. The substrate 330 is for example a silicon carbide-based substrate. In addition, the substrate 330 may be various types of substrates such as 4H-SiC, 6H-SiC, 3C-SiC or 15R-SiC according to types of elements or products to be finally fabricated on the epitaxial wafer.

The epitaxial structure 340 may be disposed on the substrate 330 and may be doped with an n-type or p-type dopant. The epitaxial structure 340 may include a buffer layer (or first epitaxial layer) 342 formed by epitaxial growth and an active layer (or second epitaxial layer) 344 formed by epitaxial growth.

The buffer layer 342 is disposed on the substrate 330 and the active layer 344 is disposed on the buffer layer 342. When the substrate 330 is a silicon carbide-based substrate, the buffer layer 342 and the active layer 344 may also be formed of a doped silicon carbide-based material. The buffer layer 342 may be doped at a first doping concentration and the active layer 344 may be doped at a second doping concentration.

The buffer layer 342 is provided to reduce crystal defects caused by difference in lattice constant between the substrate 330 and the active layer 344 and the first doping concentration is greater than the second doping concentration. For example, the first doping concentration of the buffer layer 342 is $5\times10^{17}$/cm$^3$ to $7\times10^{18}$/cm$^3$, and the second doping concentration of the active layer 344 is $1\times10^{15}$/cm$^3$ to $2\times10^{16}$/cm$^3$.

In accordance with the embodiment exemplarily shown in FIGs. 5 and 6, the buffer layer 342 and the active layer 344 have a doping uniformity of 9% or less.

When the substrate 330 is implemented by silicon carbide (SiC), each of the buffer layer 342 and the active layer 344 may include silicon carbide. For example, each of the buffer layer 342 and the active layer 344 may include n-type conductive silicon carbide, that is, silicon carbon nitride (SiCN), but the embodiment is not limited thereto. In accordance with another embodiment, each of the buffer layer 342 and the active layer 344 may include p-type conductive silicon carbide, that is, aluminum silicon carbide (AlSiC), but the embodiment is not limited thereto.

The epitaxial wafer 300B exemplarily shown in FIG. 5 may be applied to various semiconductor devices, like the epitaxial wafer 300A exemplarily shown in FIG. 4.

Referring to FIG. 6, the substrate 330 is disposed in the reaction chamber (step 260). The step 260 may be the same as the step 210 exemplarily shown in FIG. 2.

After the step 260, a reactive gas is injected into the chamber while rotating the substrate 330 at a predetermined rotation speed to dope and grow an epitaxial structure 340 by doping on the substrate 330 (steps 270 and 280).

First, the substrate 330 is rotated at a predetermined rotation speed and at the same time, a reactive gas for doping growth of the buffer layer 342 is injected into the chamber to grow the buffer layer 342 on the substrate 330 (step 270).

Then, the substrate 330 is rotated at a predetermined rotation speed and a reactive gas for doping growth of the active layer 344 is injected into the chamber to grow an active layer 344 on the buffer layer 342 (step 280).

The reactive gas used for the steps 270 and 280 may include a growth gas (or growth source) serving as a source of epitaxial growth of the buffer layer 342 or the active layer 344, a doping gas (or doping source or source gas) used for doping during the growth step, and a diluent gas used for diluting the doping gas, but the embodiment is not limited thereto.

In accordance with the embodiment not forming part of the invention, in the steps 270 and 280, the rotation speed of the substrate 330, injection parameters of the reactive gas and the dilution ratio of the growth gas are controlled. The controls of the rotation speed of the substrate 330, injection parameters of the reactive gas and the dilution ratio of the growth gas may be carried out using the following method.

For example, in the case in which the substrate 330 on which epitaxial structure 340 is grown is a silicon carbide-based substrate (for example, 4H-SiC substrate), a liquid, vapor or solid substance (or compound) containing carbon and silicon such as $SiH_4+C_3H_8+H_2$, MTS ($CH_3SiCl_3$), TCS ($SiHCl_3$), $Si_xC_x$ ($1 \le x \le 17$), $Si_xC_y$ ($1 \le x \le 17$, $1 \le y \le 18$) which is a material which matches in lattice constant with the substrate 330 may be used as the growth gas for epitaxial growth.

In the case in which the buffer layer 342 and the active layer 344 laminated on the substrate 330 through the epitaxial growth step described above are doped with an n-type dopant, a Group V element such as nitrogen ($N_2$) gas may be used as the doping gas, but the embodiment is not limited to the substance of the doping gas.

In addition, the growth gas may be changed according to material and type of the substrate 330 on which the buffer layer 342 and the active layer 344 are laminated. In addition, the doping gas actually involved in doping may also be changed according to the doping type (n-type or p-type). Hereinafter, for convenience and concentration of description, the following description is given based on the assumption that epitaxial doping-growth is performed on the silicon carbide-based substrate 110 using a nitrogen gas as the doping gas.

In addition, the following description is based on the assumption that hydrogen gas ($H_2$) is used as the diluent gas for diluting the nitrogen gas which is the doping gas, but the embodiment is not limited thereto. For example, an inert gas (for example, Ar or He) may be used as the diluent gas.

In the step 270, in order to grow the buffer layer 342, an injection parameter of the reactive gas is controlled to 10 mℓ/min to 45 mℓ/min and a ratio of flux of the growth gas to the flux of the diluent gas is controlled to 1/4,000 to 1/3,000 under the conditions that a ratio of carbon to silicon (C/Si) is 0.5 to 0.8, a temperature is 1,600°C to 1,650°C, and a pressure is 70 mbar to 120 mbar.

In the step 280, in order to grow the active layer 344, an injection parameter of the reactive gas is controlled to 1 mℓ/min to 20 mℓ/min and a ratio of flux of the growth gas to flux of the diluent gas is controlled to 1/1,000 to 1/600 under the conditions that the ratio (C/Si) is 0.8 to 1.2, the temperature is 1,600°C to 1,650°C, and the pressure is 70 mbar to 120 mbar.

The injection parameter of the reactive gas may be defined by the following Equation 3.

[Equation 3]

$$\text{Injection parameter} = \frac{(a_1 \times \text{flux of reactive gas injected into chamber} + b_1)}{(a_2 \times \text{flux of doping gas} + b_2) \times (a_3 \times \text{flux of doping gas} + a_4 \times \text{flux of diluent gas} + b_3)}$$

In Equation 3, $a_1$ to $a_4$ represent positive real numbers, and bi to $b_3$ represent real numbers. For example, $a_1=a_2=a_3=a_4=1$ and $b_1=b_2=b_3=0$. Units of the flux of the reactive gas, the flux of the doping gas and the flux of the diluent gas are mℓ/min.

When the buffer layer 342 is formed in the step 270, the reactive, doping and diluent gases may be injected such that the injection parameter shown in Equation 3 satisfies 1/45 min/mℓ to 1/10 min/mℓ (that is, 10 mℓ/min to 45 mℓ/min).

In addition, when the active layer 344 is formed in the step 280, the reactive, doping and diluent gases may be injected such that the injection parameter described in Equation 3 above satisfies 1/20 min/mℓ to 1 min/mℓ (that is, 1 mℓ/min to 20 mℓ/min).

Meanwhile, the doping gas is supplied through an inlet provided in the chamber and is discharged through an outlet, thereby maintaining a concentration of the doping gas in the chamber. However, because, in actual, the concentration of doping gas in the vicinity of an area in which the inlet is disposed may be higher than the concentration of doping gas in the vicinity of an area in which the outlet is disposed, it is disadvantageously impossible to supply a doping gas at a uniform concentration over the entire surface from a center to an edge of the substrate 330. Accordingly, during the steps 270 and 280, a concentration of doping gas supplied to the substrate 330 may be uniformly maintained by suitably controlling the rotation speed of the substrate 330.

For example, during the steps 270 and 280, the rotation speed of the substrate 330 may be controlled to 50 rpm to 70 rpm (that is, 50 to 70 revolutions per minute).

Under the afore-mentioned conditions, Example and Comparative Example wherein epitaxial doping growth is performed on the substrate 330 are exemplarily shown in FIGs. 7 to 10.

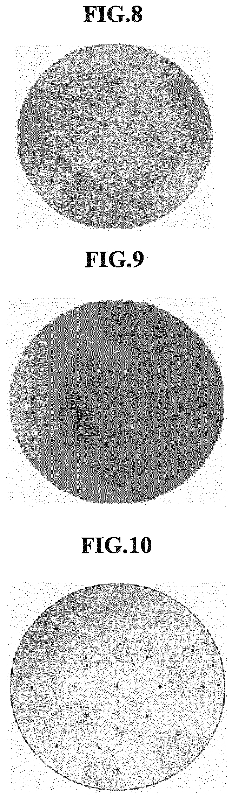

FIGs. 7 and 8 show the buffer layer 342 and the active layer 344 epitaxially doped and grown on the 4-inch substrate 330 according to the example, and FIGs. 9 and 10 show the buffer layer 342 and the active layer 344 epitaxially doped and grown thereon according to comparative example.

The buffer layer 342 and the active layer 344 exemplarily shown in FIGs. 7 and 8 are measured using a C-V (capacitance versus voltage) meter. As a result, the buffer layer 342 of FIG. 7 has a doping uniformity represented by Equation 1 described above, of 8.65% and the active layer 344 of FIG. 8 has a doping uniformity of 8.62%. As such, it may be seen that doping uniformities of the buffer layer 342 and the active layer 344 are 9% or less under the conditions of satisfying the rotation speed of the substrate 330, the injection parameter of the reactive gas and the dilution ratio of the growth gas according to the present embodiment not forming part of the invention.

On the other hand, the buffer layer 342 epitaxially doped and grown under the same conditions, except that the rotation speed of the substrate 330 is set to 40 rpm, is exemplarily shown in FIG. 9. In addition, the active layer 344 epitaxially doped and grown under the same conditions, except that the rotation speed of the substrate 330 is set to a level higher than 70 rpm, is exemplarily shown in FIG. 10. The buffer layer 342 and the active layer 344 exemplarily shown in FIGs. 9 and 10 are measured using a C-V (capacitance versus voltage) meter. As a result, the buffer layer 342 exemplarily shown in FIG. 9 has a mean doping concentration of $6.79 \times 10^{17}/cm^3$, a standard deviation of $2.06 \times 10^{17}/cm^3$ and a doping uniformity of 30.35%. In addition, the active layer 344 exemplarily shown in FIG. 10 has a mean doping concentration of $2.08 \times 10^{15}/cm^3$, a standard deviation of $3.12 \times 10^{14}/cm^3$ and a doping uniformity of 14.98%.

As such, when the rotation speed of the substrate 330 is set to 40 rpm, doping uniformity is deteriorated and a deviation of the doping concentration is increased. In addition, when the rotation speed of the substrate 330 is set to a level higher than 70 rpm, the doping uniformity is about 15%, but deviation of doping concentration and thickness difference are increased and defect ratio is thus increased.

As may be seen from the fact that generally-used products have a doping uniformity of about 15%, doping uniformity of the epitaxial structure 300B doped and grown under the conditions according to the present embodiment not forming part of the invention is considerably excellent.

The epitaxial doping growth through control of the above conditions may be continued until the active layer 344 is grown to the designed target thickness.

In the fabrication process of the epitaxial wafer according to the present embodiment not forming part of the invention, the growth speed at which the buffer layer 342 is grown may be lower than the growth speed at which the active layer 344 is grown. For example, the growth speed at which the buffer layer 342 is set to, for example, 1 $\mu$m/h to 3 $\mu$m/h (that is, a speed at which the epitaxial layer is laminated to a thickness of 1 $\mu$m to 3 $\mu$m per hour).

When epitaxial growth is performed at a high growth speed, uniform lamination (growth) may be generally difficult. Accordingly, in the process of growing the buffer layer 342, mobility between atoms through the reactive gas is activated by maintaining the predetermined growth speed and an environment enabling even growth is thus provided, and time enabling the atoms to be uniformly distributed and grown on the substrate may be secured by reducing the growth speed. The process of growing the buffer layer 342 is effective in reducing lattice mismatch and considerably decreasing surface defects. The process of growing the buffer layer 342 is a preliminary process for reducing basal plane dislocation (BPD) caused by lattice mismatch and difference in thermal expansion coefficient between the substrate 330 and the active layer 344. Accordingly, it is enough that the thickness of the buffer layer 342 is about 0.5 $\mu$m to 1.0 $\mu$m.

Then, the process of growing the active layer 344 enables epitaxial growth at a speed higher than a speed at which the buffer layer 342 is grown. For example, the process of growing the active layer 344 may be performed at a speed of 20 $\mu$m/h or more. The process of growing the active layer 344 may be performed until a total thickness of the epitaxial structure 340 reaches a desired target growth thickness. The target thickness may be changed according to utilization purpose and application of epitaxial wafers, features of final elements and products, design specification and the like.

In accordance with the embodiment not forming part of the invention, the growth of the buffer layer 342 and the growth of the active layer 344 are continuously performed without intermission. That is, the buffer layer growth and the active layer growth may be continuously performed while not stopping injection of the reactive gas (while not stopping the growth step). The continuous performance of the growth step may be carried out by the following methods.

First, growth of the active layer 344 may be performed immediately after growth of the buffer layer 342. Alternatively, an intermediate growth step may be interposed between the growth of the active layer 344 and the growth of the buffer layer 342. The intermediate growth step is a process which grows an epitaxial layer by injecting the reactive gas at a growth speed which increases linearly or stepwise from the growth speed in the process of growing the buffer layer 342 after injecting a reactive gas into the chamber to the growth speed in the process of growing the active layer 344.

The epitaxial wafer 300B according to the another embodiment may have an improved doping uniformity of 9% or less and exhibit high qualities such as enhanced properties and yield.

The epitaxial wafers 300A and 300B described above may be applied to metal semiconductor field effect transistors (MESFETs). For example, the metal semiconductor field effect transistor (MESFET) is fabricated by forming an ohmic contact layer including a source and drain on the second epitaxial layers 324 and 344 according to the present embodiment. Furthermore, epitaxial wafers 300A and 300B according to the embodiments may be applied to various semiconductor devices.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

**Claims**

1. A method (200A) for fabricating an epitaxial wafer (300A; 300B), comprising a silicon carbide substrate (110; 310; 330) and an epitaxial structure (320; 340) disposed on the silicon carbide substrate (310; 330), said epitaxial structure (320; 340) comprising a first epitaxial layer (117; 322; 342) and a second epitaxial layer (119; 324; 344) disposed on the first epitaxial layer (117; 322; 342);, each of the first (117; 322; 342) and second epitaxial layers (119; 324; 344) comprising silicon carbide, said method comprising the following steps:

   • a step of disposing (210) the silicon carbide substrate (110; 310; 330) in a reaction chamber;
   • a step of injecting in the reaction chamber (220) a reactive gas include a growth gas for epitaxial growth and a doping gas,

   wherein said growth gas includes silicon and carbon, wherein said doping gas includes a dilution gas and a source gas containing said an n-type or p-type dopant,

   • a step of rotating (230) said silicon carbide substrate (110; 310; 330) at a predetermined and controlled rotation speed that is set to be comprised between 50 rpm and 100 rpm, and controlling the dilution ratio of the source gas in the doping gas wherein the dilution ratio of the source gas in the doping gas is given by the following expression:

   $$\text{dilution ratio} = \text{flux of source gas} / \text{flux of doping gas} \; ; \P$$

   • a step of growing (240) an epitaxial layer (115, 117, 119, 322, 342, 324, 344) comprising a pregrowing step of the first epitaxial layer (117; 322; 342) on the silicon carbide substrate (310; 330), and a growing step of the second epitaxial layer (119; 324; 344) on the first epitaxial layer (115, 117; 322; 342) ;

   wherein during the pregrowth step, the dilution ratio of the source gas is controlled to be set within 1/70 to 1/30 and the C/Si ratio of the epitaxial layers is of 0,7 to less than 1, and
   during the growth step the dilution ratio of the source gas is controlled to be set within 1/100 to 1/10 and the C/Si ratio of the epitaxial layers is 1 or more, thus leading to a standard deviation from the mean concentration of dopant of said epitaxial structure (320; 340) from a center to an edge of the epitaxial wafer being of 10% or less of the mean concentration of dopant.

2. The method (200A) according to claim 1, wherein the standard deviation from the mean concentration of dopant of said epitaxial structure from a center to an edge of the epitaxial wafer is 9% or less of the mean concentration of dopant.

3. The method (200A) according to claim 2, wherein the first epitaxial layer (117; 322; 342) is disposed between the silicon carbide substrate (110; 310; 330) and the second epitaxial layer (119; 324; 344) so that leakage current induced when applying voltage to the epitaxial wafer (300A; 300B) is suppressed.

4. The method (200A) according to any of claims 1 and 3, wherein the first epitaxial layer (117; 322; 342) is disposed between the silicon carbide substrate (110; 310; 330) and the second epitaxial layer (119; 324; 344) so that lattice mismatch between the silicon carbide substrate (110; 310; 330) and the second epitaxial layer (119; 324; 344) is reduced, thereby reducing surface defects of the second epitaxial layer (119; 324; 344).

5. The method (200A) according to any of claims 3 and 4, wherein the second epitaxial layer (119; 324; 344) has a surface defect density of $0.5/cm^2$ or less.

6. The method (200A) according to any of claims 3 to 5, wherein a composition of the first epitaxial layer (117; 322; 342) is the same as that of the second epitaxial layer (119; 324; 344).

7. The method (200A) according to any of claims 3 to 6, wherein the first epitaxial layer (117; 322; 342) is doped at a first doping concentration, the second epitaxial layer (119; 324; 344) is doped at a second doping concentration, and the first doping concentration is greater than the second doping concentration.

8. The method (200A) according to any of claims 3 to 7, wherein each of the first (117; 322; 342) and second epitaxial layers (119; 324; 344) doped with an n-type dopant comprises silicon carbon nitride, SiCN.

9. The method (200A) according to any of claims 3 to 7, wherein each of the first (117; 322; 342) and second epitaxial layers (119; 324; 344) doped with a p-type dopant comprises aluminum silicon carbide, AlSiC.

10. The method (200A) according to any of claims 3 to 9, wherein the first epitaxial layer (117; 322; 342) has a thickness of 1.0 $\mu$m or less.

11. The method (200A) according to claim 10, wherein the first epitaxial layer (117; 322; 342) has a thickness of 0.5 $\mu$m to 1.0 $\mu$m.


**Patentansprüche**

1. Verfahren (200A) zur Herstellung eines epitaktischen Wafers (300A; 300B), der ein Siliciumcarbid-Substrat (110; 310; 330) und eine epitaktische Struktur (320; 340) umfasst, die auf dem Siliciumcarbid-Substrat (310; 330) angeordnet ist, wobei die epitaktische Struktur (320; 340) eine erste epitaktische Schicht (117; 322; 342) und eine zweite epitaktische Schicht (119; 324; 344) umfasst, die auf der ersten epitaktischen Schicht (117; 322; 342) angeordnet ist, wobei jede aus der ersten (117; 322; 342) und zweiten epitaktischen Schicht (119; 324; 344) Siliciumcarbid umfasst, wobei das Verfahren die folgenden Schritte umfasst:

- einen Schritt des Anordnens (210) des Siliciumcarbid-Substrats (110; 310; 330) in einer Reaktionskammer;
- einen Schritt des Injizierens eines reaktiven Gases, das ein Wachstumsgas für epitaktisches Wachstum und ein Dotiergas einschließt, in die Reaktionskammer (220),

wobei das Wachstumsgas Silicium und Kohlenstoff einschließt, wobei das Dotiergas ein Verdünnungsgas und ein Quellengas einschließt, das einen n-Typ- oder p-Typ-Dotierstoff enthält,

- einen Schritt des Drehens (230) des Siliciumcarbid-Substrats (110; 310; 330) bei einer vorbestimmten und gesteuerten Drehzahl, die so eingestellt wird, dass sie im Bereich zwischen 50 U/min und 100 U/min liegt, und Steuerns des Verdünnungsverhältnisses des Quellengases im Dotiergas, wobei das Verdünnungsverhältnis des Quellengases im Dotiergas vom folgenden Ausdruck wiedergegeben wird:

$$\text{Verdünnungsverhältnis} \quad = \quad \text{Quellengasstrom} \quad /$$

$$\text{Dotiergasstrom;}$$

- einen Schritt des Aufwachsens (240) einer epitaktischen Schicht (115, 117, 119, 322, 342, 324, 344), der einen Schritt des Voraufwachsens der ersten epitaktischen Schicht (117; 322; 342) auf dem Siliciumcarbid-Substrat (310; 330), und einen Schritt des Aufwachsens der zweiten epitaktischen Schicht (119; 324; 344) auf der ersten epitaktischen Schicht (115, 117; 322; 342) umfasst;

wobei
während des Vorwachstumsschritts das Verdünnungsverhältnis des Quellengases so gesteuert wird, dass es innerhalb 1/70 bis 1/30 eingestellt ist, und das C/Si-Verhältnis der epitaktischen Schichten 0,7 bis weniger als 1 beträgt, und
während des Wachstumsschritts das Verdünnungsverhältnis des Quellengases so gesteuert wird, dass es innerhalb 1/100 bis 1/10 eingestellt ist, und das C/Si-Verhältnis der epitaktischen Schichten 1 oder mehr beträgt, was dazu führt, dass eine Standardabweichung von der mittleren Dotierstoff-Konzentration der epitaktischen Struktur (320; 340) von einem Mittelpunkt zu einem Rand des epitaktischen Wafers 10 % oder weniger der mittleren Dotierstoff-Konzentration beträgt.

2. Verfahren (200A) nach Anspruch 1, wobei die Standardabweichung von der mittleren Dotierstoff-Konzentration der epitaktischen Struktur von einem Mittelpunkt zu einem Rand des epitaktischen Wafers 9 % oder weniger der mittleren Dotierstoff-Konzentration beträgt.

3. Verfahren (200A) nach Anspruch 2, wobei die erste epitaktische Schicht (117; 322; 342) so zwischen dem Siliciumcarbid-Substrat (110; 310; 330) und der zweiten epitaktischen Schicht (119; 324; 344) angeordnet ist, dass Leckstrom, der induziert wird, wenn Spannung an den epitaktischen Wafer (300A; 300B) angelegt wird, unterdrückt wird.

4. Verfahren (200A) nach einem der Ansprüche 1 und 3, wobei die erste epitaktische Schicht (117; 322; 342) so zwischen dem Siliciumcarbid-Substrat (110; 310; 330) und der zweiten epitaktischen Schicht (119; 324; 344) angeordnet ist, dass Gitterfehlanpassung zwischen dem Siliciumcarbid-Substrat (110; 310; 330) und der zweiten epitaktischen Schicht (119; 324; 344) reduziert wird, wodurch Oberflächendefekte der zweiten epitaktischen Schicht (119; 324; 344) reduziert werden.

5. Verfahren (200A) nach einem der Ansprüche 3 und 4, wobei die zweite epitaktische Schicht (119; 324; 344) eine Oberflächendefekt-Dichte von $0,5/cm^2$ oder weniger aufweist.

6. Verfahren (200A) nach einem der Ansprüche 3 bis 5, wobei eine Zusammensetzung der ersten epitaktischen Schicht (117; 322; 342) dieselbe ist wie jene der zweiten epitaktischen Schicht (119; 324; 344).

7. Verfahren (200A) nach einem der Ansprüche 3 bis 6, wobei die erste epitaktische Schicht (117; 322; 342) mit einer ersten Dotierungskonzentration dotiert wird, die zweite epitaktische Schicht (119; 324; 344) mit einer zweiten Dotierungskonzentration dotiert wird, und die erste Dotierungskonzentration höher ist als die zweite Dotierungskonzentration.

8. Verfahren (200A) nach einem der Ansprüche 3 bis 7, wobei jede aus der ersten (117; 322; 342) und zweiten epitaktischen Schicht (119; 324; 344), die mit einem n-Typ-Dotierstoff dotiert wird, Silicium-Kohlenstoff-Nitrid, SiCN, umfasst.

9. Verfahren (200A) nach einem der Ansprüche 3 bis 7, wobei jede aus der ersten (117; 322; 342) und zweiten epitaktischen Schicht (119; 324; 344), die mit einem p-Typ-Dotierstoff dotiert wird, Aluminium-Silicium-Carbid, AlSiC, umfasst.

10. Verfahren (200A) nach einem der Ansprüche 3 bis 9, wobei die erste epitaktische Schicht (117; 322; 342) eine Dicke von 1,0 $\mu$m oder weniger aufweist.

11. Verfahren (200A) nach Anspruch 10, wobei die erste epitaktische Schicht (117; 322; 342) eine Dicke von 0,5 $\mu$m bis 1,0 $\mu$m aufweist.

**Revendications**

1. Procédé (200A) pour la fabrication d'une tranche épitaxiale (300A ; 300B), comprenant un substrat de carbure de silicium (110 ; 310 ; 330) et une structure épitaxiale (320 ; 340) disposée sur le substrat de carbure de silicium (310 ; 330), ladite structure épitaxiale (320 ; 340) comprenant une première couche épitaxiale (117 ; 322 ; 342) et une seconde couche épitaxiale (119 ; 324 ; 344) disposée sur la première couche épitaxiale (117 ; 322 ; 342), chacune des première (117 ; 322 ; 342) et seconde couches épitaxiales (119 ; 324 ; 344) comprenant du carbure de silicium, ledit procédé comprenant les étapes suivantes :

   - une étape de disposition (210) du substrat de carbure de silicium (110 ; 310 ; 330) dans une chambre de réaction ;
   - une étape d'injection dans la chambre de réaction (220) d'un gaz réactif qui comporte un gaz de croissance pour la croissance épitaxiale et un gaz dopant,

   dans lequel ledit gaz de croissance comporte du silicium et du carbone, dans lequel ledit gaz dopant comporte un gaz de dilution et un gaz source contenant un dopant de type n ou de type p,

   - une étape de mise en rotation (230) dudit substrat de carbure de silicium (110 ; 310 ; 330) à une vitesse de rotation prédéterminée et contrôlée qui est réglée pour être comprise entre 50 tr/min et 100 tr/min, et de contrôle du rapport de dilution du gaz source dans le gaz dopant dans lequel le rapport de dilution du gaz source dans le gaz dopant est donné par l'expression suivante :

   ```
   rapport de dilution = flux de gaz source / flux de
   gaz dopant ;
   ```

   - une étape de croissance (240) d'une couche épitaxiale (115, 117, 119, 322, 342, 324, 344) comprenant une étape de pré-croissance d'une première couche épitaxiale (117 ; 322 ; 342) sur le substrat de carbure de silicium (310 ; 330), et une étape de croissance de la seconde couche épitaxiale (119 ; 324 ; 344) sur la première couche épitaxiale (115 ; 117 ; 322 ; 342) ;

   dans lequel pendant l'étape de pré-croissance, le rapport de dilution du gaz source est contrôlé pour être réglé entre 1/70 et 1/30 et le rapport C/Si des couches épitaxiales est de 0,7 à moins de 1, et pendant l'étape de croissance, le rapport de dilution du gaz source est contrôlé pour être réglé entre 1/100 et 1/10 et le rapport C/Si des couches épitaxiales est de 1 ou plus, conduisant ainsi à un écart type de la concentration moyenne de dopant de ladite structure épitaxiale (320 ; 340) d'un centre vers un bord de la tranche épitaxiale étant de 10 % ou moins de concentration moyenne de dopant.

2. Procédé (200A) selon la revendication 1, dans lequel l'écart type par rapport à la concentration moyenne de dopant de ladite structure épitaxiale d'un centre vers un bord de la tranche épitaxiale est de 9 % ou moins de la concentration moyenne de dopant.

3. Procédé (200A) selon la revendication 2, dans lequel la première couche épitaxiale (117 ; 322 ; 342) est disposée entre le substrat de carbure de silicium (110 ; 310 ; 330) et la seconde couche épitaxiale (119 ; 324 ; 344) de sorte qu'un courant de fuite induit lors de l'application d'une tension à la tranche épitaxiale (300A ; 300B) soit supprimé.

4. Procédé (200A) selon l'une quelconque des revendications 1 et 3, dans lequel la première couche épitaxiale (117 ; 322 ; 342) est disposée entre le substrat de carbure de silicium (110 ; 310 ; 330) et la seconde couche épitaxiale (119 ; 324 ; 344) de sorte qu'une désadaptation de réseau entre le substrat de carbure de silicium (110 ; 310 ; 330) et la seconde couche épitaxiale (119 ; 324 ; 344) soit réduite, réduisant ainsi les défauts de surface de la seconde couche épitaxiale (119 ; 324 ; 344).

5. Procédé (200A) selon l'une quelconque des revendications 3 et 4, dans lequel la seconde couche épitaxiale (119 ; 324 ; 344) a une densité de défauts de surface de $0,5/cm^2$ ou moins.

6. Procédé (200A) selon l'une quelconque des revendications 3 à 5, dans lequel une composition de la première couche épitaxiale (117 ; 322 ; 342) est la même que celle de la seconde couche épitaxiale (119 ; 324 ; 344).

**7.** Procédé (200A) selon l'une quelconque des revendications 3 à 6, dans lequel la première couche épitaxiale (117 ; 322 ; 342) est dopée à une première concentration de dopage, la seconde couche épitaxiale (119 ; 324 ; 344) est dopée à une seconde concentration de dopage, et la première concentration de dopage est supérieure à la seconde concentration de dopage.

**8.** Procédé (200A) selon l'une quelconque des revendications 3 à 7, dans lequel chacune des première (117 ; 322 ; 342) et seconde couches épitaxiales (119 ; 324 ; 344) dopée avec un dopant de type n comprend du nitrure de carbure de silicium, SiCN.

**9.** Procédé (200A) selon l'une quelconque des revendications 3 à 7, dans lequel chacune des première (117 ; 322 ; 342) et seconde couches épitaxiales (119 ; 324 ; 344) dopée avec un dopant de type p comprend du carbure de silicium d'aluminium, AlSiC.

**10.** Procédé (200A) selon l'une quelconque des revendications 3 à 9, dans lequel la première couche épitaxiale (117 ; 322 ; 342) a une épaisseur de 1,0 $\mu$m ou moins.

**11.** Procédé (200A) selon la revendication 10, dans lequel la première couche épitaxiale (117 ; 322 ; 342) a une épaisseur de 0,5 $\mu$m à 1,0 $\mu$m.

# FIG.1

CONTROL OF INJECTION
FLUX OF REACTIVE GAS

(a)

115

110 — 4H-SiC substrate

PRE-GROWTH STEP

(b)

117

115

110 — 4H-SiC substrate

(c)

119

117

115

110 — 4H-SiC substrate

GROWTH STEP

# FIG.2

**200A**

```
        ┌─────────────┐
        │    START    │
        └──────┬──────┘
               │
               ▼
┌──────────────────────────────────────┐
│   DISPOSING  SUBSTRATE  IN  CHAMBER   │  ～ 210
└──────────────────┬───────────────────┘
                   │
                   ▼
┌──────────────────────────────────────┐
│  INJECTING  REACTIVE  GAS  FOR  EPITAXIAL │  ～ 220
│  DOPING-GROWTH  INTO  CHAMBER         │
└──────────────────┬───────────────────┘
                   │
                   ▼
┌──────────────────────────────────────┐
│  ROTATING  SUBSTRATE  AT  PREDETERMINED │  ～ 230
│  ROTATION  SPEED  AND  CONTROLLING    │
│  DILUTION  RATIO  OF  SOURCE  GAS  IN │
│  DOPING  GAS                          │
└──────────────────┬───────────────────┘
                   │
                   ▼
┌──────────────────────────────────────┐
│  GROWING  EPITAXIAL  LAYER  TO  TARGET │  ～ 240
│  THICKNESS  BY  INJECTING  REACTIVE  GAS │
│  ONTO  SUBSTRATE  AT  PREDETERMINED   │
│  GROWTH  TEMPERATURE                  │
└──────────────────┬───────────────────┘
                   │
                   ▼
        ┌─────────────┐
        │    END      │
        └─────────────┘
```

# FIG.3

DOPING UNIFORMITY

NUMBER OF TESTS

**FIG.4**

<u>**300A**</u>

**FIG.5**

<u>**300B**</u>

## FIG.6

**START**

200B

DISPOSING SUBSTRATE IN CHAMBER ～ 260

GROWING BUFFER LAYER BY CONTROLLING INJECTION PARAMETER OF REACTIVE GAS AND DILUTION RATIO OF GROWTH GAS WITH ROTATING SUBSTRATE ～ 270

GROWING ACTIVE LAYER BY CONTROLLING INJECTION PARAMETER OF REACTIVE GAS AND DILUTION RATIO OF GROWTH GAS WITH ROTATING SUBSTRATE ～ 280

**END**

## FIG.7

**FIG.8**

**FIG.9**

**FIG.10**